(19) Europäisches Patentamt
European Patent Office
Office européen des brevets

(11) **EP 2 966 703 A1**

(12) **EUROPEAN PATENT APPLICATION**


(43) Date of publication:
**13.01.2016 Bulletin 2016/02**

(51) Int Cl.:
***H01L 51/46*** *(2006.01)*

(21) Application number: **14176831.7**

(22) Date of filing: **11.07.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**



(71) Applicant: **Ecole Polytechnique Fédérale de Lausanne (EPFL)**
**1015 Lausanne (CH)**

(72) Inventors:
- **Li, Xiang**
  **1006 Lausanne (CH)**
- **Zakeeruddin, Shaik Mohammad**
  **1030 Bussigny (CH)**
- **Graetzel, Michael**
  **1025 St-Sulpice (CH)**

(74) Representative: **Ganguillet, Cyril**
**ABREMA**
**Agence Brevets & Marques Ganguillet**
**Avenue du Théâtre 16**
**P.O. Box 5027**
**1002 Lausanne (CH)**


(54) **Template enhanced organic inorganic perovskite heterojunction photovoltaic device**


(57) The present invention relates to a solid state photovoltaic device comprising a light-absorbing layer containing a light harvester and at least one templating agent, said light-absorbing layer being prepared in a single step.


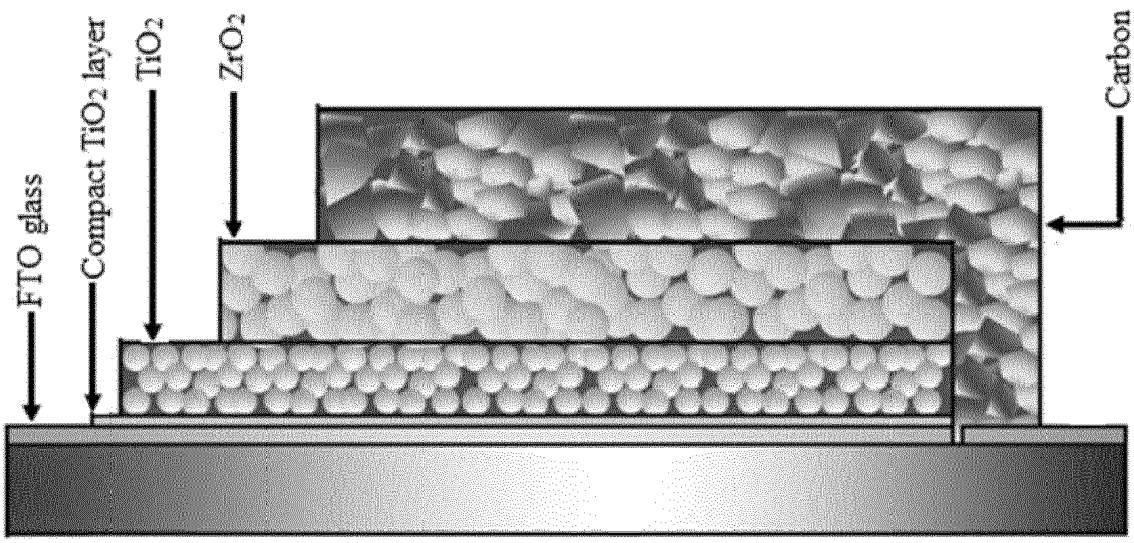


**Figure 2**

EP 2 966 703 A1

## Description

### Technical Field

The present invention relates to solid state photovoltaic devices, solid state solar cells, solid-state heterojunctions and flat junctions comprising a light-absorbing layer containing a light harvester, in particular an organic-inorganic perovskite, and a templating agent, especially carboxylic acid derivatives and salts, and to a method for preparing said solid state photovoltaic devices.

### Prior Art and the Problem Underlying the Invention

Photovoltaic (PV) cells that convert sunlight into electricity are becoming increasingly important in the world's energy mix. So far the field of PV market has been dominated by solid-state p-n junction devices made from silicon, CdTe or Copper indium gallium selenide (CIGS), which benefit from the experience and material availability of the semiconductor industry. However, these cells still encounter major obstacles to attain the terawatt production scale required for making a major impact on future market developments due to the need for high purity materials and energy intensive manufacturing processes.

In the past decades, a new solar cell conceptually based on mesoscopic inorganic or organic semiconductors with interconnected three-dimensional structure (sandwich/monolithic-type PV devices consisting of a mesoporous photoanode with an organic/inorganic light harvester, redox electrolyte/solid-state hole conductor, and counter electrode) such as the dye sensitized solar cells (DSSCs) has attracted extensive attention because of the abundant sources of raw materials and the prospect of inexpensive production, which avoid expensive and energy intensive elevated temperature and high vacuum processes. The highest certified efficiency of electrolyte based DSSCs is currently 11.9% while that of the solid-state version employing an organic hole conductor is only 6%.

Recently, organic-inorganic metal halide perovskites are attracting large attention as light harvesters in mesoscopic solar cells having rapidly reached conversion efficiencies over 15%. Organic-inorganic hybrid semiconductors have been introduced as light harvester to replace traditional metal-organic complex or organic molecules. The most common of organic-inorganic hybrid semiconductors is the methylammonium lead halide perovskite ($CH_3NH_3PbX_3$, X =halogen) and its mixed-halide crystal analogue. European patent application EP 12179323.6 discloses a solid-state solar cell comprising one or more organic-inorganic perovskite layers and showing remarkable conversion efficiencies even though in absence of organic hole transporting material. These perovskites have a large absorption coefficient, high carrier mobility, direct band gap and high stability, rendering them attractive for use in optoelectronic applications. Importantly, they are comprised of earth-abundant materials and can be deposited by low-temperature solution methods such as spin-coating or drop casting, which forebodes well for future large scale manufacturing of the cells.

However, the methylammonium lead halide perovskite and its mixed-halide analogue also encounter several critical issues. Thus, the perovskite crystallization from solution is difficult to control, which leads to produce many morphological variations and incomplete filling of the mesoporous metal oxide layer and metal oxide nanoscaffold structure. Resulting devices have a poor reproducibility of photovoltaic performances with a wide variability of efficiency, what hinders prospects for practical applications.

Also present perovskite embodiments generally use gold or silver as back contact in conjunction with organic hole conductors acting as electron blocking layers. Hole conductor such as the widely used arylamine *spiro*-OMeTAD is not only very expensive but, in its oxidized form, it is able to lead to device instability and to serious predicament for the long-term stability of the device. Hole conductor-free perovskite photovoltaics have first been reported by L. Etgar et al.(2012, J. Am. Chem. Soc. 134. 17396). So far the best power conversion efficiency (*PCE*) was 8%using gold as a counter electrode.

The present invention addresses the disadvantage organic hole transporting material, which provides instability to the device, when said hole transporter material is in oxidized form, as it is the case of spiro-MeOTAD.

The present invention also addresses the replacement of the counter electrode material such as noble metal by abundantly available and low-cost material presenting similar properties as the counter electrode in noble metal.

The present invention addresses the disadvantage of poor performance reproducibility of perovskite containing phototovoltaic devices caused by uncontrolled deposition of perovskite on the nanoporous metal oxide layer or metal oxides nanoscaffold structure and of the defectuous filling of the pores of nanoporous metal oxide layer or metal oxides nanoscaffold structure.

The present invention addresses the disadvantage of the defect concentration of the perovskite crystal formation on the metal oxide layer, which does not lead to the appropriate filling of the pores of the metal oxide layer being in close electric contact with the metal oxide layer_to increase the photo_conversion and photocurrent generation of the whole device and therefore the efficiency and the performance of the photovoltaic device.

The invention pursues to provide an efficient solar cell, which can be rapidly prepared in an efficient way, using

readily available or low cost materials such as conductive material, using a short manufacturing procedure based on industrially known manufacturing step, keeping the material costs and the material impact on the environment very low.

The present invention addresses the problems depicted above.

## Summary of the Invention

Remarkably, in some aspects, the present inventors have found that adding at least one templating agent into the solution of the light harvester, in particular an organic-inorganic perovskite, to prepare and form the light-absorbing layer of a solid state photovoltaic device enhances the crystal growth of the light harvester or the perovskite as well as the device performance and stability. This results in a device having a light-absorber layer showing a longer exciton lifetime and higher quantum yield for photo-induced charge separation compared to a device having a light-absorber layer without a templating agent.

The presence of the templating agent improves the control of the perovskite crystal nucleation and quality as well as the loading of the mesostructure_comprising one or more mesoporous metal oxide layers, if said mesostructure being present in the solid state photovoltaic device. The infiltration and the pore filling of the mesoporous layers by the light-absorber layer therefore are improved.

Furthermore, the one single step preparation of the light-absorbing layer by mixing the templating agent with the light-harvester in solution before their application onto the electron selective hole blocking layer and/or the mesostructure is economically and environmentally advantageous for the production of the solid state photovoltaic device.

In an aspect, the present invention provides a solid state photovoltaic device comprising a light-absorbing layer containing a light harvester and at least one templating agent, said light-absorbing layer being prepared in a single step.

In an aspect, the present invention provides a solid state photovoltaic device comprising a light-absorbing layer containing a light-harvester and at least one templating agent.

Further aspects and preferred embodiments of the invention are detailed herein below and in the appended claims. Further features and advantages of the invention will become apparent to the skilled person from the description of the preferred embodiments given below.

## Brief Description of the Drawings

Figure 1 shows chemical structures of templating agents 5-AVAI (5-Aminovaleric acid hydroiodide), 5-APACl (5-aminopentanamide hydrochloride) and 4-ABPACl (4-aminobutylphosphonic acid hydrochloride)

Figure 2 shows a schematic cross section of the triple layer perovskite based fully printable mesoscopic solar cell. The mesoporous layers of $TiO_2$ and $ZrO_2$ have a thickness of ca. 1 and 2 μm, respectively, and are deposited on a FTO covered glass sheet shown in grey color. They are infiltrated with the mixture of templating agent and perovskite by drop casting from solution.

**Figure 3** shows SEM images of the top surfaces of **(A)** $MAPbI_3$ and **(B)** $MAPbI_3$ together with 5-Aminovaleric acid hydroiodide (5-AVAI) deposited on $ZrO_2/TiO_2$ scaffolds and of the cross-section of **(C)** $MAPbI_3$ (MA: methyl ammonium) and **(D)** $MAPbI_3$ treated by 5-AVAI mesoscopic solar cells.

Figure 4 shows photocurrent density *vs.* voltage (*J-V*) curves measured under AM1.5G (100 mW $cm^{-2}$) conditions at room temperature for perovskite treated by 5-AVAI (solid line) or untreated perovskite (dashed line).

**Figure 5** shows photocurrent density *vs.* voltage (*J-V*) curves measured under simulated AM 1.5 solar irradiation (100 mW·$cm^{-2}$) at room temperature for **(A)** perovskite treated by mixed templating agents 5-AVAI and 5-APACl (solid line) or **(B)** untreated perovskite (dashed line).

**Figure 6** shows solid-state device with metal counter electrode and its cross-sectional mesostructure. **(A)** Real solid-state device. **(B)** Cross-sectional structure of the device. **(C)** Cross sectional SEM image of the device.

**Figure 7** shows SEM images of the top surfaces of **(A)** $MAPbI_3$ and **(B)** $MAPbI_3$ together with (4-ABPACl) deposited on $TiO_2$ scaffolds, and of the cross-section of **(C)** $MAPbI_3$ and (D) $MAPbI_3$ together with 4-ABPACl deposited on $TiO_2$ scaffolds. The observed pattern indicates that there is a much denser coverage and more uniform over-layer of perovskite film on the top of the mesoporous $TiO_2$ layer with $(4\text{-ABPA})_xMA_{(1-x)}PbI_{3-x}Cl_x$ as compared to MAPbI3.

**Figure 8** shows SEM images of the cross-section of $MAPbI_3$ (left) and $MAPbI_3$ together with 4-ABPACl (right) deposited within the mesoporous $TiO_2$ layer. The observed pattern indicates that the templating agent 4-ABPACl help the perovskite to completely and uniformly coat on the surface of $TiO_2$ nanoparticle. In contrast, in case of without treatment by templating agents, the load of $MAPbI_3$ by single step solution precipitation within the pores of mesoporous $TiO_2$ layer is completely absent.

**Figure 9** shows UV-vis adsorption spectra of $MAPbI_3$ together with 4-ABPACl (right) deposited on the FTO/cl-$TiO_2$/mp-$TiO_2$, the cl-$TiO_2$ and mp-$TiO_2$ are short form for the compact layer $TiO_2$ and mesoporous $TiO_2$ layer, respectively. This indicates that the templating agent 4-ABPACl can make the perovskite film absorb an augmented magnitude of the light.

**Figure 10** shows photocurrent density *vs.* voltage (*J-V*) curves measured under AM1.5G (100 mW $cm^{-2}$) conditions at room temperature for perovskite treated by 4-ABPACl (solid line) or untreated perovskite (dashed line).

**Figure 11** shows photocurrent density *vs.* voltage (*J-V*) curves measured under AM1.5G (100 mW $cm^{-2}$) conditions at room temperature for perovskite treated by 4-ABPACl and 5-APACl (solid line) or untreated perovskite (dashed line).

## Detailed Description of the Preferred Embodiments

The present invention concerns a solid state photovoltaic device comprising a light-absorbing layer containing a light harvester and at least one templating agent. In particular the present invention concerns a solid state photovoltaic device comprising a light-absorbing layer containing a light harvester and at least one templating agent and being prepared in a single step.

A templating agent is defined as a compound providing the control of the nucleation of a light harvester, in particular of an organic-inorganic perovskite, into the mesoporous layers of metal oxide as well as its infiltration into the mesoporous layers of metal oxide. The molecular structure of said templating agent may facilitate the anchoring of the light harvester onto the metal oxide layer and/or into the mesoporous layers of metal oxide. Without to be bound by the theory, the molecule structure of said templating agent may serve as a pattern for the production of the molecular structure of a complex formed between the light harvester and the templating agent in reaction, wherein said complex comprises mixed cations provided by the templating agent and the light harvester being in particular an organic-inorganic perovskite.

The templating agent is therefore selected from organic or inorganic compound, amino acid derivatives, carboxylic acid derivatives, aminocarboxylic acid derivatives, which is added to the solution of a light harvester preferably being an organic-inorganic perovskite to prepare a light absorbing layer, preferably in one step.

In an aspect of the invention, the solid state photovoltaic device comprises a light-absorbing layer containing a light harvester and at least one templating agent, preferably 1, 2 or 3 templating agents being different from each other, said light-absorbing layer being prepared in one single step. The at least one templating agent in solution is added to the light harvester in solution. The resulting composition or mixture is applied onto the metal oxide layer of the electron selective hole blocking layer and/or the metal oxide films of the mesostructure.

According to an embodiment, the templating agent of the solid state photovoltaic device of the invention is independently selected from a compound of formula (1)

$$W^1\text{-}U\text{-}W^2\text{-}Z \qquad (1),$$

wherein

$W^1$ is selected from COOH, $PO_3H_2$, $PO_4H_2$, $SO_3H_2$, $SO_4H_2$, CONHOH, and salts thereof;
U is selected from a linear or branched C1 to C30 alkyl;
$W^2$ is a cation selected from $-NH3^+$, $-NH-C(NH_3^+)=NH$, $-N=CH-NH_3^+$; and
Z is an anion selected from Cl, Br, I, CN, NCO, NCS and NCSe.

If two or more templating agents are present, they are all different.

According to a further embodiment, U may be selected from a linear or branched C1-C30 alkyl, C2-C30 alkyl, C3-C30 alkyl, C4-C30 alkyl, C5-C30 alkyl, C6-C30 alkyl, C7-C30 alkyl, C2-C20 alkyl, C3-C20 alkyl, C4-C20 alkyl. Preferably, L is selected from C4 alkyl and $L^2$ is selected from OH or $NH_2$.

In a further embodiment U may be selected from C1 to C10 alkyl, C2 to C10 alkenyl, C2 to C10 alkynyl, C4 to C10 heteroaryl and C6 to C10 aryl, wherein said alkyl, alkenyl, and alkynyl, if they comprise 3 or more carbons, may be linear, branched or cyclic, and may be unsubstituted or substituted by C1 to C10 alkyl, C2 to C10 alkenyl, C2 to C10 alkynyl, C4 to C10 heteroaryl and C6 to C10 aryl and/or may comprise 1 to 8 heteroatom selected from N, S and O. Preferably, neighboring heteroatoms are absent and/or heteroatom-heteroatom bonds are absent.

In a preferred embodiment, $W^1$ is selected from COOH and CONHOH, and salts thereof, $W^2$ is a cation selected from $-NH3^+$, $-NH-C(NH_3^+)=NH$, $-N=CH-NH_3^+$; and Z is an anion selected from Cl, Br, I, CN, NCO, NCS and NCSe.

According to an embodiment, the light harvester of the light-absorbing layer of the photovoltaic device is selected from organic, inorganic, organometallic and organic-inorganic pigments or a combination thereof. The light harvester is preferably a light absorbing compound or material. Preferably, the light harvester is a pigment, and most preferably the light harvester is an organic-inorganic pigments.

According to a preferred embodiment, the light harvester of the light-absorbing layer of the solid state photovoltaic device of the invention is an organic-inorganic perovskite.

The term "perovskite", for the purpose of this specification, refers to the "perovskite structure" and not specifically to the perovskite material, CaTiO3. For the purpose of this specification, "perovskite" encompasses and preferably relates to any material that has the same type of crystal structure as calcium titanium oxide and of materials in which the bivalent cation is replaced by two separate monovalent cations. The perovskite structure has the general stoichiometry $AMX_3$, where "A" and "M" are cations and "X" is an anion. The "A" and "M" cations can have a variety of charges and in the original Perovskite mineral ($CaTiO_3$), the A cation is divalent and the M cation is tetravalent. For the purpose of this invention, the perovskite formulae includes structures having three (3) or four (4) anions, which may be the same or different, and/or one or two (2) organic cations, and/or metal atoms carrying two or three positive charges, in accordance with the formulae presented elsewhere in this specification.

In particular, the light harvester of the light-absorbing layer of the solid state photovoltaic device of the invention is an organic-inorganic perovskite of any one of formulae (I), (II), (III), (IV), (V) and/or (VI) below:

$AA'MX_4$ (I)

$AMX_3$ (II)

$AA'N_{2/3}X^4$ (III)

$AN_{2/3}X_3$ (IV)

$BN_{2/3}X_4$ (V)

$BMX_4$ (VI)

wherein,

A and A' are organic, monovalent cations that are independently selected from primary, secondary, tertiary or quaternary organic ammonium compounds, including N-containing heterorings and ring systems, A and A' having independently from 1 to 60 carbons and 1 to 20 heteroatoms;
B is an organic, bivalent cation selected from primary, secondary, tertiary or quaternary organic ammonium compounds having from 1 to 60 carbons and 2-20 heteroatoms and having two positively charged nitrogen atoms;
M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$;
N is selected from the group of $Bi^{3+}$ and $Sb^{3+}$; and,
X are independently selected from $Cl^-$, $Br^-$, $I^-$, $NCS^-$, $CN^-$, and $NCO^-$.

In particular, the three or four X may be the same or different. For example, in $AMX_3$(formula II) may be expressed as formula (II') below:

$AMX^iX^{ii}X^{iii}$ (II')

wherein $X^i$, $X^{ii}$, $X^{iii}$ are independently selected from $Cl^-$, $Br^-$, $I^-$, $NCS^-$, $CN^-$, and $NCO^-$, preferably from halides ($Cl^-$, $Br^-$, $I^-$), and A and M are as defined elsewhere in this specification. $X^i$, $X^{ii}$, $X^{iii}$ may thus be the same or different in this case. The same principle applies to the perovskites of formulae (I) and (III)-(VI) and the more specific embodiments of formulae (VIII) to (XIV) below. In case of $AA'MX_4$(formula I), for example, formula (I') applies:

$AA'MX^iX^{ii}X^{iii}X^{iv}$ (I')

wherein $X^i$, $X^{ii}$, $X^{iii}$ are independently selected from $Cl^-$, $Br^-$, $I^-$, $NCS^-$, $CN^-$, and $NCO^-$, preferably from halides ($Cl^-$, $Br^-$, $I^-$).

Preferably, if $X^i$, $X^{ii}$, $X^{iii}$ in formulae (II) and (IV) or $X^i$, $X^{ii}$, $X^{iii}$, $X^{iv}$ in formulae (I), (III), (V) or (VI) comprise different anions X, there are not more than two different anions. For example, $X^i$ and $X^{ii}$ being the same with $X^{iii}$ being an anion that is different from $X^i$ and $X^{ii}$.

According to a preferred embodiment, the organic-inorganic perovskite has the structure selected from one or more of formulae (I) to (III), preferably (II) or (II').

According to a preferred embodiment, said organic-inorganic perovskite comprises a perovskite-structure of any one of the formulae (VIII) to (XIV):

$APbX_3$ (VIII)

$ASnX_3$ (IX)

$ABiX_4$ (X)

$AA'PbX_4$ (XI)

$AA'SnX_4$ (XII)

$BPbX_4$ (XIII)

$BSnX_4$ (XIV)

wherein A, A', B and X are as defined elsewhere in this specification. Preferably, X is preferably selected from $Cl^-$, $Br^-$ and $I^-$, most preferably X is $I^-$.

According to a preferred embodiment, said organic-inorganic perovskite layer comprises a perovskite-structure of the formulae (VIII) to (XII), more preferably (VIII) and/or (IX) above.

According to an embodiment, A and A', for example in AX and/or in any one of formulae (I) to (IV), and (VIII) to (XII), are monovalent cations selected independently from any one of the compounds of formulae (1) to (8) below:

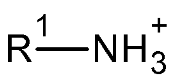
(2)

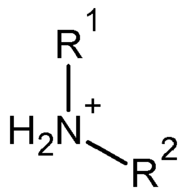
(3)

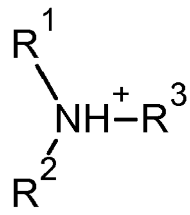
(4)

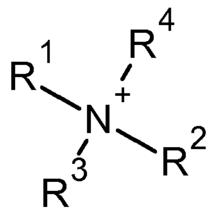
(5)

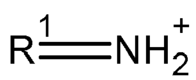
(6)

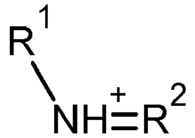
(7)

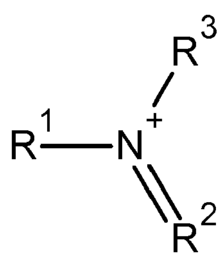
(8)

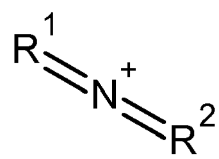
(9)

wherein,

any one of $R^1$, $R^2$, $R^3$ and $R^4$ is independently selected from C1-C15 organic substituents comprising from 0 to 15 heteroatoms.

According to an embodiment of said C1-C15 organic substituent any one, several or all hydrogens in said substituent may be replaced by halogen and said organic substituent may comprise up to fifteen (15) N, S or O heteroatoms, and wherein, in any one of the compounds (3) to (9), the two or more of substituents present ($R^1$, $R^2$, $R^3$ and $R^4$, as applicable) may be covalently connected to each other to form a substituted or unsubstituted ring or ring system. Preferably, in a chain of atoms of said C1-C15 organic substituent, any heteroatom is connected to at least one carbon atom. Preferably, neighboring heteroatoms are absent and/or heteroatom-heteroatom bonds are absent in said C1-C15 organic substituent comprising from 0 to 15 heteroatoms.

According to an embodiment any one of $R^1$, $R^2$, $R^3$ and $R^4$ is independently selected from C1 to C15 aliphatic and C4 to C15 aromatic or heteroaromatic substituents, wherein any one, several or all hydrogens in said substituent may be replaced by halogen and wherein, in any one of the compounds (3) to (9), the two or more of the substituents present may be covalently connected to each other to form a substituted or unsubstituted ring or ring system.

According to an embodiment, B is a bivalent cation selected from any one of the compounds of formulae (10) and (11) below:

$R_1$-L-$R_2$ (10)

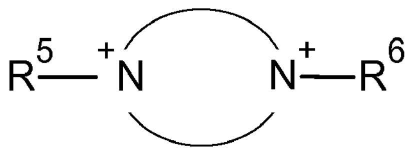

(11)

wherein,

in the compound of formula (10), L is an organic linker structure having 1 to 10 carbons and 0 to 5 heteroatoms selected from N, S, and/or O, wherein any one, several or all hydrogens in said L may be replaced by halogen;

wherein any one of $R_1$ and $R_2$ is independently selected from any one of the substituents (12) to (17) below:

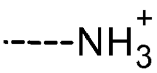

(12)

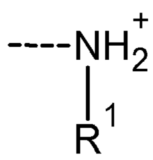

(13)

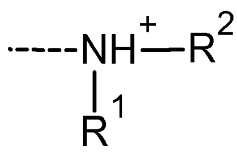

(14)

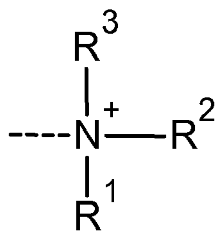

(15)

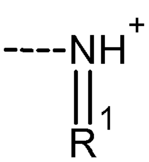

(16)

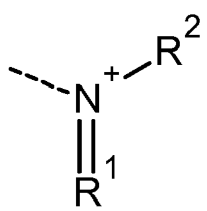

(17)

wherein the dotted line in the substituents (12) to (17) represents the bond by which said substituent is connected to the linker structure L;

wherein $R^1$, $R^2$, and $R^3$ are independently as defined above with respect to the compounds of formulae (2) to (9);

wherein $R_1$ and $R^2$, if they are both different from substituent (12), may be covalently connected to each other by way of their substituents $R^1$, $R^2$, and/or $R^3$, as applicable, and wherein any one of $R^1$, $R^2$, and $R^3$, if present, may be covalently connected to L or the ring structure of compound (11), independently from whether said substituent is present on $R_1$ or $R_2$;and wherein, in the compound of formula (11), the circle containing said two positively charged nitrogen atoms

represents a substituted or unsubstituted aromatic ring or ring system comprising 4 to 15 carbon atoms and 2 to 7 heteroatoms, wherein said nitrogen atoms are ring heteroatoms of said ring or ring system, and wherein the remaining of said heteroatoms may be selected independently from N, O and S and wherein $R^5$ and $R^6$ are independently selected from H and from substituents as $R^1$ to $R^4$. Halogens substituting hydrogens totally or partially may also be present in addition to and/or independently of said 2 to 7 heteroatoms.

Preferably, if the number of carbons is in L is impair, the number of heteroatoms is smaller than the number of carbons. Preferably, in the ring structure of formula (11), the number of ring heteroatoms is smaller than the number of carbon atoms.

According to an embodiment, L is an aliphatic, aromatic or heteroaromatic linker structure having from 1 to 10 carbons.

Preferably, the dotted line in substituents (12) to (17) represents a carbon-nitrogen bond, connecting the nitrogen atom shown in the substituent to a carbon atom of the linker.

According to an embodiment, in the compound of formula (10), L is an organic linker structure having 1 to 8 carbons and from 0 to 4 N, S and/or O heteroatoms, wherein any one, several or all hydrogens in said L may be replaced by halogen. Preferably, L is an aliphatic, aromatic or heteroaromatic linker structure having 1 to 8 carbons, wherein any one, several or all hydrogens in said L may be replaced by halogen.

According to an embodiment, in the compound of formula (10), L is an organic linker structure having 1 to 6 carbons and from 0 to 3 N, S and/or O heteroatoms, wherein any one, several or all hydrogens in said L may be replaced by halogen. Preferably, L is an aliphatic, aromatic or heteroaromatic linker structure having 1 to 6 carbons, wherein any one, several or all hydrogens in said L may be replaced by halogen.

According to an embodiment, in the compound of formula (10), said linker L is free of any O or S heteroatoms. According to an embodiment, L is free of N, O and/or S heteroatoms.

According to an embodiment, in the compound of formula (11), the circle containing said two positively charged nitrogen atoms represents a substituted or unsubstituted aromatic ring or ring system comprising 4 to 10 carbon atoms and 2 to 5 heteroatoms (including said two ring N-atoms).

According to an embodiment, said ring or ring system in the compound of formula (11) is free of any O or S heteroatoms. According to an embodiment, said ring or ring system in the compound of formula (11) is free of any further N, O and/or S heteroatoms, besides said two N-ring atoms. This does not preclude the possibility of hydrogens being substituted by halogens.

As the skilled person will understand, if an aromatic linker, compound, substituent or ring comprises 4 carbons, it comprises at least 1 ring heteroatom, so as to provide an aromatic moiety.

According to an embodiment, any one of $R^1$, $R^2$, $R^3$ and $R^4$ is independently selected from C1 to C8 organic substituents comprising, from 0 to 4 N, S and/or O heteroatom, wherein, independently of said N, S or O heteroatoms, any one, several or all hydrogens in said substituent may be replaced by halogen, and wherein two or more of substituents present on the same cation may be covalently connected to each other to form a substituted or unsubstituted ring or ring system. Preferably, any one of $R^1$, $R^2$, $R^3$ and $R^4$ is independently selected from C1 to C8 aliphatic, C4 to C8 heteroaromatic and C6 to C8 aromatic substituents, wherein said heteroaromatic and aromatic substituents may be further substituted.

According to an embodiment, any one of $R^1$, $R^2$, $R^3$ and $R^4$ is independently selected from C1 to C6 organic substituents comprising, from 0 to 3 N, S and/or O heteroatom, wherein, independently of said N, S or O heteroatoms, any one, several or all hydrogens in said substituent may be replaced by halogen, and wherein two or more of substituents present on the same cation may be covalently connected to each other to form a substituted or unsubstituted ring or ring system. Preferably, any one of $R^1$, $R^2$, $R^3$ and $R^4$ is independently selected from C1 to C6 aliphatic, C4 to C6 heteroaromatic and C6 to C6 aromatic substituents, wherein said heteroaromatic and aromatic substituents may be further substituted.

According to an embodiment, any one of $R^1$, $R^2$, $R^3$ and $R^4$ is independently selected from C1 to C4, preferably C1 to C3 and most preferably C1 to C2 aliphatic substituents wherein any one, several or all hydrogens in said substituent may be replaced by halogen and wherein two or more of substituents present on the same cation may be covalently connected to each other to form a substituted or unsubstituted ring or ring system.

According to an embodiment, any one of $R^1$, $R^2$, $R^3$ and $R^4$ is independently selected from C1 to C10 alkyl, C2 to C10 alkenyl, C2 to C10 alkynyl, C4 to C10 heteroaryl and C6 to C10 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in $R^1$-$R^4$ may be replaced by halogen.

According to an embodiment, any one of $R^1$, $R^2$, $R^3$ and $R^4$ is independently selected from C1 to C8 alkyl, C2 to C8 alkenyl, C2 to C8 alkynyl, C4 to C8 heteroaryl and C6 to C8 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in $R^1$-$R^4$ may be replaced by halogen.

According to an embodiment, any one of $R^1$, $R^2$, $R^3$ and $R^4$ is independently selected from C1 to C6 alkyl, C2

to C6 alkenyl, C2 to C6 alkynyl, C4 to C6 heteroaryl and C6 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in $R^1$-$R^4$ may be replaced by halogen.

According to an embodiment, any one of $R^1$, $R^2$, $R^3$ and $R^4$ is independently selected from C1 to C4 alkyl, C2 to C4 alkenyl and C2 to C4 alkynyl, wherein said alkyl, alkenyl and alkynyl, if they comprise 3 or more carbons, may be linear, branched or cyclic, and wherein several or all hydrogens in in $R^1$-$R^4$ may be replaced by halogen.

According to an embodiment, any one of $R^1$, $R^2$, $R^3$ and $R^4$ is independently selected from C1 to C3, preferably C1 to C2 alkyl, C2 to C3, preferably C2 alkenyl and C2 to C3, preferably C2 alkynyl, wherein said alkyl, alkenyl and alkynyl, if they comprise 3 or more carbons, may be linear, branched or cyclic, and wherein several or all hydrogens in $R^1$-$R^4$ may be replaced by halogen.

According to an embodiment, any one of $R^1$, $R^2$, $R^3$ and $R^4$ is independently selected from C1 to C4, more preferably C1 to C3 and even more preferably C1 to C2 alkyl. Most preferably, any one of $R^1$, $R^2$, $R^3$ and $R^4$ are methyl. Again, said alkyl may be completely or partially halogenated.

According to an embodiment, A, A' and B are monovalent (A, A') and bivalent (B) cations, respectively, selected from substituted and unsubstituted C5 to C6 rings comprising one, two or more nitrogen heteroatoms, wherein one (for A and A') or two (for B) of said nitrogen atoms is/are positively charged. Substituents of such rings may be selected from halogen and from C1 to C4 alkyls, C2 to C4 alkenyls and C2 to C4 alkynyls as defined above, preferably from C1 to C3 alkyls, C3 alkenyls and C3 alkynyls as defined above. Said ring may comprise further heteroatoms, which may be selected from O, N and S. Bivalent organic cations B comprising two positively charged ring N-atoms are exemplified, for example, by the compound of formula (11) above. Such rings may be aromatic or aliphatic, for example.

A, A' and B may also comprise a ring system comprising two or more rings, at least one of which being from substituted and unsubstituted C5 to C6 ring as defined as above. The elliptically drawn circle in the compound of formulae (11) may also represent a ring system comprising, for example, two or more rings, but preferably two rings. Also if A and/or A' comprises two rings, further ring heteroatoms may be present, which are preferably not charged, for example.

According to an embodiment, however, the organic cations A, A' and B comprise one (for A, A'), two (for B) or more nitrogen atom(s) but are free of any O or S or any other heteroatom, with the exception of halogens, which may substitute one or more hydrogen atoms in cation A and/or B.

A and A' preferably comprise one positively charged nitrogen atom. B preferably comprises two positively charged nitrogen atoms.

A, A' and B may be selected from the exemplary rings or ring systems of formulae (18) and (19) (for A) and from (20) to (22) (for B) below:

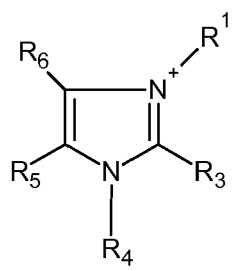

(18)

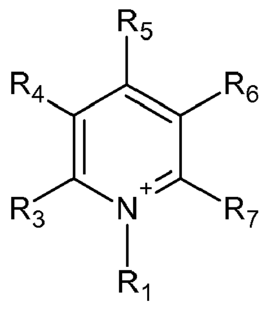

(19)

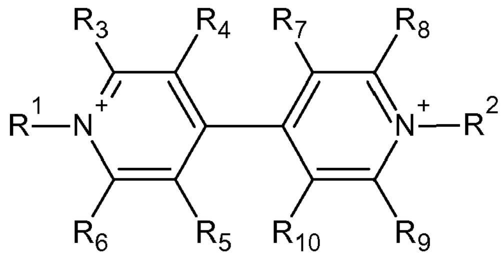
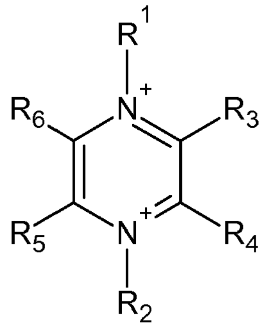
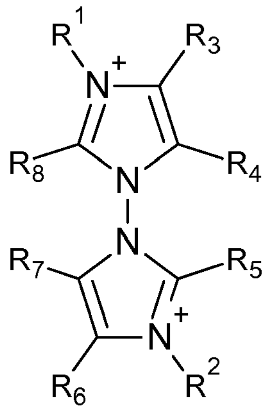

(20) (21) (22)

in which $R^1$ and $R^2$ are, independently, as defined above, and $R_3$, $R_4$, $R_5$, $R_6$, $R_7$, $R_8$, $R_9$ and $R_{10}$ are independently selected from H, halogen and substituents as defined above for $R^1$ to $R^4$. Preferably, $R_3$-$R_{10}$ are selected from H and halogen, most preferably H.

In the organic cations A, A' and B, hydrogens may be substituted by halogens, such as F, Cl, I, and Br, preferably F or Cl. Such a substitution is expected to reduce the hygroscopic properties of the perovskite layer or layers and may thus provide a useful option for the purpose of the present specification.

According to a preferred embodiment, A and A' are independently selected from organic cations of formula (1). Preferably, $R^1$ in the cation of formula (1) is selected from C1 to C8 organic substituents comprising, from 0 to 4 N, S and/or O heteroatom. More preferably, $R^1$ is selected from C1 to C4, preferably C1 to C3 and most preferably C1 to C2 aliphatic substituents.

According to a preferred embodiment, the metal M is selected from $Sn^{2+}$ and $Pb^{2+}$, preferably $Pb^{2+}$. According to a preferred embodiment, N is $Sb^{3+}$.

According to a preferred embodiment, the three or four X are independently selected from $Cl^-$, $Br^-$, and $I^-$.

According to a preferred embodiment, the organic-inorganic perovskite material has the formula of formulae (XV) to (XIX) below:

$AMI_3$ (XV)

$AMI_2Br$ (XVI)

$AMI_2Cl$ (XVII)

$AMBr_3$ (XVII)

$AMCl_3$ (XIX)

wherein A and M are as defined elsewhere in this specification, including the preferred embodiments of A and M, such as those defined below. Preferably, M is selected from $Sn^{2+}$ and $Pb^{2+}$. Preferably, A is selected from organic cations of formula (1). Preferably, $R^1$ in the cation of formula (1) is selected from C1 to C8 organic substituents comprising, from 0 to 4 N, S and/or O heteroatom. More preferably, $R^1$ is selected from C1 to C4, preferably C1 to C3 and most preferably C1 to C2 aliphatic substituents.

According to a preferred embodiment, the organic-inorganic perovskite is a compound of formula (VII) ($AMX^iX^{ii}X^{iii}$), wherein A is a monovalent cation of formula (1) as defined above, M is as defined elsewhere in this specification, and $X^i$, $X^{ii}$, $X^{iii}$ are independently selected from $Cl^-$, $Br^-$, $I^-$. Preferably, $R^1$ in the cation of formula (1) is selected from C1 to C4, preferably C1 to C3 and most preferably C1 to C2 aliphatic substituents.

According to a preferred embodiment, the organic-inorganic perovskite is a compound of formula (VII) ($AMX^iX^{ii}X^{iii}$), wherein A is a monovalent cation of formula (1) as defined above, M is $Sn^{2+}$ or $Pb^{2+}$, and $X^i$, $X^{ii}$, $X^{iii}$ are independently selected from $Cl^-$, $Br^-$, $I^-$. Preferably, $R^1$ in the cation of formula (1) is selected from C1 to C4, preferably C1 to C3 and most preferably C1 to C2 aliphatic substituents. Preferably, $X^i$ -$X^{iii}$ are identical.

In the moieties of formula (1) to (22), the connection of any moiety to quinozilinoacridine core, a preceding moiety or a following moiety (for example, if one or the other of the integer m, n is different from 0) is illustrated by way

of a dashed line representing the bond indicating the connection between said moieties.

Without to be bound by the theory, when the at least one templating agent is mixed with a solution of an organic inorganic perovskite, new formed crystals of the light harvester comprise mixed cations provided by the templating agent and the organic cation of the perovskite. Thus, e.g., when a solution comprising $PbI_2$, methylammonium(MA) iodide and 5-ammoniumvaleric acid hydroiodide (5-AVAI) iodide or a solution comprising $PbI_2$, methylammonium (MA) iodide and 5-ammoniumvaleric acid hydroiodide (5-AVAI) and 5-aminopentaamide hydrochloride (5-APAHCl) is drop-casted into the solid state photovoltaic device of the invention, new mixed cation perovskites $(5\text{-AVA})_x(MA)_{(1-x)}PbI_3$ or $(5\text{-APA})_x(5\text{-AVA})_y(MA)_{(1-x-y)}PbI_3$, respectively, form crystals showing lower defect concentration and better pore filling. Moreover, the role of the cation of the templating agent selected from a compound of formula (1) is to template the formation of perovskite crystals in the mesostructure or onto the metal oxide of the electrode selective hole blocking layer. It also improves the loading of the mesopores of the oxide scaffold in the presence of 5-AVA cations. The 5-AVA is endowed with COOH-groups that anchor a monolayer of the amino-acid to the surface of the mesoporous metal oxide film such as $TiO_2$ and $ZrO_2$ film by coordinative binding to the exposed Ti(IV) or Zr(IV) ions, e.g. In the adsorbed state the terminal, $-NH_3^+$ groups of 5-AVA face the perovskite solution and hence serve as a nucleation site templating the formation of the perovskite crystals. The second additive, 5-APA, plays a crucial role in introducing the amide group on the boundary of the perovskite crystals and there by extending the hydrogen bonding between the neighboring perovskite crystals as well as between the carboxylic acid group belonging to the perovskite crystals. In this fashion 5-AVA produces a condensed conformal over-layer of the perovskite in intimate contact with the mesoscopic oxide film ascertaining rapid and highly efficient electron injection from the mixed cation halide perovskite $(5\text{-AVA})_x(5\text{-APA})_y\,(MA)_{(1-x-y)}PbI_3$ into the $TiO_2$ conduction band.

For example, the light absorbing layer may be applied by any one or more methods selected from drop casting, spin-coating, dip-coating, curtain coating and spray-coating. Preferably, the light-absorbing layer is applied in one single step. The step consists of the application of a composition or a mixture comprising at least one templating agent and two precursor of an organic-inorganic perovskite, e.g., by drop-casting through a whole selective back contact or counter electrode being porous, or through the mesostructure if present on the electron selective hole blocking layer. Said composition or mixture may be applied directly on the electron selective hole blocking layer by any one or more methods as above-mentioned.

In another embodiment, the light harvester may comprise one or more pigments of the group consisting of organometallic sensitizing compounds (pthalocyanine derived compounds, porphyrine derived compounds), metal free organic sensitizing compounds (diketopyrrolopyrrole (DPP) based sensitizer), inorganic sensitizing compounds such as quantum dots, $Sb_2S_3$ (Antimonysulfide, for example in the form of thin films), aggregates of organic pigments, nanocomposites, in particular organic-inorganic perovskites, and combinations of the aforementioned. For the purpose of the invention, it is in principle possible to use any type of dyes, including combinations of different types of dyes or different dyes of the same type.

Organometallic sensitizers are disclosed, for example, in EP0613466, EP0758337, EP 0983282, EP 1622178, WO2006/038823, WO2009/107100, WO2010/055471 and WO2011/039715. Exemplary organic dyes are those disclosed in WO2009/098643, EP1990373, WO2007/100033 for example. An organic dye was also used in European patent application no. EP11161954.0. and in PCT/IB2011/054628. Metal free organic sensitizers such as DPP based compounds are disclosed, for example, in PCT/IB2013/056648 and in European patent application no. EP12182817.2.

In a further embodiment, the solid state photovoltaic device of the invention further comprises a current collector being coated by an electron selective hole blocking layer being selected from n-type metal oxide, PCBM-like $C_{60}$ derivatives and fullerene derivatives, and a whole selective back contact, characterized in that the light-absorbing layer is in electric contact with the electron selective hole blocking layer and with the hole selective back contact.

For the purpose of the present specification, the expression "in electric contact with" means that electrons or holes can get from one layer to the other layer with which it is in electric contact, at least in one direction. In particular, considering the electron flow in the operating device exposed to electromagnetic radiation, layers through which electrons and/or holes are flowing are considered to be in electric contact. The expression "in electric contact with" does not necessarily mean, and preferably does not mean, that electrons and/or holes can freely move in any direction between the layers.

The current collector is preferably substantially transparent. "Transparent" means transparent to at least a part, preferably a major part of the visible light. Preferably, the conducting support layer is substantially transparent to all wavelengths or types of visible light. Furthermore, the conducting support layer may be transparent to non-visible light, such as UV and IR radiation, for example.

According to an embodiment, the current collector is a conducting support layer providing the support layer of the solar cell of the invention. Preferably, the solar cell is built on said support layer. According to another embodiment, the support of the solar cell is provided on the side of the counter electrode or the whole selective back contact. In this case, the conductive support layer does not necessarily provide the support of the device, but may simply be or comprise a current collector, for example a metal foil.

The current collector, collecting the current obtained from the solar cell may comprise a material selected from indium doped tin oxide (ITO), fluorine doped tin oxide (FTO), ZnO-$Ga_2O_3$, ZnO-$Al_2O_3$, tin-oxide, antimony doped tin oxide (ATO), $SrGeO_3$ and zinc oxide, preferably coated on a transparent substrate, such as plastic or glass. In this case, the plastic or glass provides the support structure of the layer and the cited conducting material provides the conductivity. Such support layers are generally known as conductive glass and conductive plastic, respectively, which are thus preferred conducting support layers in accordance with the invention. According to an embodiment, the conducting support layer comprises a conducting transparent layer, which may be selected from conducting glass and from conducting plastic.

The current collector is preferably arranged to collect and conduct the current generated in the working electrode or photoanode. Therefore, the current collector is preferably in electric contact with the working electrode or photoanode.

The current collector is coated by an electron selective hole blocking layer being selected from n-type metal oxide, PCBM-like C60 and fullerene derivatives. The electron selective hole blocking layer may comprise one, two or more n-type metal oxide layers being compact or porous, if two or more layer being present, each n-type metal oxide layer is of a different type. The electron selective hole blocking layer preferably hinders or prevents electron flow in the opposite direction and/or charge recombination.

The electron selective hole blocking layer of the solid state photovoltaic device of the invention comprises a metal oxide being an oxide of a metal selected from Ti, Sn, Fe, Zn, W, Mo, Nb, SrTi, Si, Ti, Al, Cr, Sn, Mg, Mn, Zr, Ni, and Cu. The electron selective hole blocking layer of the solid state photovoltaic device of the invention comprises fullerene derivatives selected from selected from [6,6]-phenyl-$C_{61}$-butyric acid methyl ester PCBM-like C60 or PCBM), 1,4,5,8,9,11-hexazatriphenylene-hexacarbonitrile (HAT-CN), ($C_{60}$-$I_h$)[5,6]fullerene (C60), (C70-D5h)[5,6]fullerene (C70), [6,6]-Phenyl $C_{71}$ butyric acid methyl ester (PC70BM), 2,9-dimethyl-4,7-diphenyl-1,10-phenanthroline (BCP), 1,3,5-tri(phenyl-2-benzimi-dazolyl)-benzene (TPBI), preferably PCBM, HAT-CN, C60, C70, PC70BM. PCBM-like C60 being a fullerene derivatives means [6,6]-phenyl $C_{61}$ butyric acid methyl ester.

In preferred embodiments, the electron selective hole blocking layer is applied by one method selected from atomic layer deposition (ALD) and chemical bath deposition (CBD). Preferably, the metal oxide layer 3 is applied by CBD. CBD typically results in layers having a thickness as specified elsewhere for the metal oxide layer. CBD typically results in a layer that is compact as such. When deposited on a porous surface, CBD generally maintains or in some cases slightly reduces the porosity of the layer onto which deposition takes place.

In a preferred embodiment, the solid state photovoltaic device of the invention further comprises a mesostructure on top of the electron selective hole blocking layer.

According to another embodiment, the mesostructure of the solid state photovoltaic device of the invention consists of one or more mesoporous metal oxide layers, each layer comprising a different metal oxide. Preferably the mesostructure consists of one, two, three or four mesoporous layers of metal oxide, each layer comprising a different metal oxide. The metal oxide of the mesoporous layer is independently selected from$SiO_2$, $TiO_2$, $SnO_2$, $Fe_2O_3$, ZnO, $WO_3$, $Nb_2O_5$, $MoO_3$, NiO, $SrTiO_3$, $ZrO_2$, and combinations thereof. According to a preferred embodiment, the mesostructure consists of two films of metal oxide selected from $TiO_2$, $ZrO_2$ or three films of metal oxide selected from $TiO_2$, NiO, $ZrO_2$.

Mesostructures function as mesoporous scaffold and may be prepared by screen printing or spin coating, for example as is conventional for the preparation of porous semiconductor (e.g. $TiO_2$) layers in DSCs. See for example, Etgar et al. cited above. Nanoporous semiconductor scaffold structures and layers have been disclosed, for example, in EP 0333641 and EP 0606453.

According to an embodiment, the solid state photovoltaic device of the invention further comprises a hole transport layer provided before the whole selective back contact. But the solid state photovoltaic device of the invention may not comprise any hole transport layer before the whole selective back contact. Therefore, the solid state photovoltaic device of the invention is free of a hole transport layer or hole transport material.

By "hole transport material", "hole transporting material", "charge transporting material", "organic hole transport material" and "inorganic hole transport material", and the like, is meant any material or composition wherein charges are transported by electron or hole movement (electronic motion) across said material or composition. The "hole transport material" is thus an electrically conductive material. Such hole transport materials, etc., are different from electrolytes. In the latter, charges are transported by diffusion of molecules.

The hole transport layer comprise a hole transporting material being selected from one or more conductive polymers being may be selected from poly(3,4-ethylenedioxythiophene):poly(styrenesulfonate) (PEDOT:PSS), poly(3,4-ethylenedioxythiophene):poly(styrenesulfonate): grapheme nanocomposite (PEDOT:PSS:graphene), poly(N-vinylcarbazole) (PVK) and sulfonated poly(diphenylamine) (SPDPA), preferably from PEDOT:PSS, PEDOT:PSS:graphene and PVK, more preferably from PEDOT:PSS. Conductive polymers may also be selected from polymers comprising polyaniline, polypyrrole, polythiophene, polybenzene, polyethylenedioxythiophene, polypropylenedioxy-thiophene, polyacetylene, and combinations of two or more of the aforementioned. The hole transporting material may also be selected from Acceptor-Donor-Acceptor(A-D-A) oligothiophenesbased on heteroacene coreas disclosed in the unpublished EP

14153558.3 and compounds based on quinozilinoacridine as disclosed in the unpublished EP 14151392.9.

According to another embodiment, the whole selective back contact or counter electrode of the solid state photovoltaic device of the invention comprises one or more conductive materials selected from Pt, Au, Ni, Cu, Ag, In, Ru, Pd, Rh, Ir, Os, C, graphene, indium doped tin oxide (ITO), fluorine doped tin oxide (FTO), ZnO-$Ga_2O_3$, ZnO-$Al_2O_3$, tin-oxide, antimony doped tin oxide (ATO), $SrGeO_3$ and combination thereof, and from conductive polymer being selected from polymers comprising polyaniline, polypyrrole, polythiophene, polybenzene, polyethylenedioxythiophene, polypropylenedioxy-thiophene, polyacetylene and combination thereof.

According to a further embodiment, the solid state photovoltaic device of the invention is selected from a solid state solar cell, a mesoscopic solid state solar cell, a solid state heterojunction and a mesoscopic solid state heterojunction, preferably from a mesoscopic solid state solar cell.

The present invention will now be illustrated by way of examples. These examples do not limit the scope of this invention, which is defined by the appended claims.

Examples

Example 1: Preparation of the 40wt% perovskite precursor solutions:

0.395g MAI (methylammonium iodide) and 1.146g $PbI_2$ were dissolved in 2ml γ-butyrolactone and then stirred at 60°C overnight. The $(5\text{-AVA})_x(MA)_{1-x}PbI_3$ precursor solution was prepared in the same manner as for the $MAPbI_3$ precursor solution, except that a mixture of 5-AVAI (5-ammoniumvaleric acid iodide) and MAI (methylammonium iodide) with the mole ratio of 1:20 to 1:30 was added. The $(5\text{-APA})_x(MA)_{1-x}PbI_{3-x}Cl_x$ precursor solution was prepared in the same manner as for the $MAPbI_3$ precursor solution, except that a mixture of 5-APACl (5-aminopentanamide hydrochloride) and MAI (methylammonium iodide) with the mole ratio of 1:20 to 1:30 was added. The $(4\text{-ABPA})_x(MA)_{1-x}PbI_{3-x}Cl_x$ precursor solution was prepared in the same manner as for the $MAPbI_3$ precursor solution, except that a mixture of 4-ABPACl (4-Aminobutylphosphonic acid hydrochloride) and MAI (methylammonium iodide) with the mole ratio of 1:20 to 1:30 was added. The $(4\text{-ABPA}))_x(5\text{-APA})y(MA)_{1-x-y}PbI_{3-x-y}Cl_{x+y}$ precursor solution was prepared in the same manner as for the $MAPbI_3$ precursor solution, except that a mixture of 4-ABPACl (4-aminobutylphosphonic acid hydrochloride), 5-APAI (5-aminopentanamide hydrochloride) and MAI (methylammonium iodide) with the mole ratio of 3:2:95 was added (see Figure 1).

In order to introduce the templating agents 5-AVA, 4-ABPA and 5-APA cation into the perovskite lattice we used a mixture of 5-AVAI, 4-ABPACl and 5-APACl in the precursor solution maintaining the total concentration of organic ammonium cations and $PbI_2$ at a 1:1 molar ratio. The optimal molar ratio of the amount of all templating agents to MAI (methylammonium iodide) in $(4\text{-ABPA})_x(5\text{-APA})y(MA)_{(1-x-y)}PbI_{3-x-y}$ was determined to be between 1:20 and 1:30.

Example 2: Preparation of the 40 mg/mL templating agent solutions:

0.2 g 5-AVAI (5-ammoniumvaleric acid iodide) was dissolved in 5ml γ-butyrolactone and then stirred at room temperature for one hour.

Example 3: Fabrication of perovskite based mesoscopic solar cells treated with 5-AVAI:

As presented in Figure 2, the FTO glass was first etched to form two separated electrodes before being cleaned ultrasonically with ethanol. Then, the patterned substrates were coated by a compact $TiO_2$ layer by aerosol spray pyrolysis, and a 1μm nanoporous $TiO_2$ layer was deposited by screen printing of a $TiO_2$ slurry, which prepared as reported previously. After being sintered at 450°C for 30min, a 2μm $ZrO_2$ space layer was printed on the top of the nanoporous $TiO_2$ layer using a $ZrO_2$ slurry, which acts as a insulating layer to prevent electrons from reaching the back contact. Finally, a carbon black/graphite counter electrode or whole selective back contact with the thickness of about 10μm was coated on the top of $ZrO_2$ layer by printing carbon black/graphite composite slurry and sintering at 400°C for 30 min. After cooling down to room temperature, a 40wt% perovskite precursor solution was infiltrated by drop casting via the top of the carbon counter electrode. After drying at 50 °C for one hour, the mesoscopic solar cells containing perovskite was obtained.

We applied transmission electron microscopy (TEM) and scanning electron microscopy (SEM) to unravel differences in the morphology of the two perovskites. Figure 3 shows a cross-sectional SEM view of the effect of the templating agent on the perovskite based mesoscopic solar cells, which confirms again the different levels of in pore filling of the perovskite with and without templating agent two. For the sample with 5-AVAI, most of the mesopores of the $TiO_2/ZrO_2$ double layer are filled with the perovskite while for the device without 5-AVAI the infiltration reveals less complete pore filling, a substantial amount of voids remaining unfilled within the mesoporous $ZrO_2/TiO_2$ film. Figures 3A and 3B display top SEM views of the morphology of the perovskite deposited by drop casting on the surface of mesoporous

$ZrO_2/TiO_2$ films in the absence of the carbon layer. In contrast to the $MAPbI_3$ film without 5-AVAI, which exhibits a loose texture with small rods, the perovskite film treated by 5-AVAI formed a smooth and compact film, consistent with complete coverage of the oxide by a capping layer of perovskite crystals. Generally, more extended crystal regions will be beneficial to reduce the hole transport resistance due to lowering of the numbers of grain boundaries. As a result, the perovskite film treated by templating agent should yield smaller resistive losses under photovoltaic operation than $MAPbI_3$ without treated by 5-AVAI.

Substantial differences appear between the morphologies of the samples produced from the two different perovskite precursor solutions. The observed pattern indicates that there is a much denser coverage of the $TiO_2$ particles with $(5\text{-AVA})_xMA1_{-x}PbI_3$ as compared to $MAPbI_3$. The $(5\text{-AVA})_xMA1_{-x}PbI_3$ appears to exhibit crystalline features on a much longer length scale than $MAPbI_3$ covering most of the $TiO_2$ surface in a uniform fashion. In contrast, the single step solution precipitation of $MAPbI_3$ only partially coats the substrate and leaving large areas uncovered where the perovskite absorber is completely absent. From these data we infer that there is more perovskite deposited on the mesoscopic $TiO_2$ films loaded by $(5\text{-AVA})_xMA1_{-x}PbI_3$ than by $MAPbI_3$. The improvement of the perovskite crystal quality and the higher loading of the mesopores of the oxide scaffold in the presence of 5-AVA cations can be rationalized in terms of a better control of the perovskite crystal nucleation and growth within the mesoscopic oxide scaffold. The 5-AVA is endowed with COOH-groups that anchor a monolayer of the amino-acid to the surface of the mesoporous $TiO_2$ and $ZrO_2$ film by coordinative binding to the exposed Ti(IV) or Zr(IV) ions. In the adsorbed state the terminal -NH3+ groups of 5-AVA face the perovskite solution and hence serve as a nucleation site templating the formation of the perovskite crystals. In this fashion 5-AVA produces a conformal over-layer of the perovskite in intimate contact with the mesoscopic oxide film ascertaining rapid and highly efficient electron injection from the $(5\text{-AVA})_x(MA)_{(1-x)}PbI_3$ into the $TiO_2$ conduction band.

The photocurrent density is measured as a function of forward bias voltage (J-V curves) of the $(5\text{-AVA})_xMA1_{-x}PbI_3$ and the $MAPbI_3$ based mesoscopic solar cells under standard reporting conditions, i.e. AM 1.5 global solar light at 100 mW $cm^{-2}$ and room temperature. The four key photovoltaic parameters, i.e. the open-circuit voltage (Voc), short-circuit photocurrent (Jsc), fill factor (FF) and PCE increase to a stable value within the first 3 minutes and then exhibit excellent stability during exposure to full AM 1.5 simulated sunlight over 1000 hours. The final power conversion efficiency (PCE) is observed to increase slightly during this period. This is even more remarkable in view of the fact that the test was performed with an unsealed device, the perovskite being protected by the 10 micron thick carbon layer back contact acting as a water retaining layer. This is the first time that such an excellent long-term stability is achieved with a solar cell that uses a perovskite as a light harvester.

Photocurrent density *vs.* voltage (*J-V*) curves measured under AM1.5G (100 mW $cm^{-2}$) conditions at room temperature for perovskite treated by 5-AVAI or untreated perovskite (see Figure 4). The slope of the *J-V* cure at open circuit voltage is steeperfor $(5\text{-AVA})_x(MA)_{(1-x)}PbI_3$ perovskite than for $MAPbI_3$, suggesting a lower series resistance for the former compared to the latter perovskite. The photovoltaic properties of these two perovskites in the mesoscopic solar cells agree well with their differences in crystal quality and the extent of filling of the mesostructured scaffold. Incomplete filling of the porous space has a negative impact on light harvesting, light induced charge separation and charge carrier percolation.

**Table 1** Photovoltaic parameters derived from *J-V* measurements of $CH_3NH_3PbI_3$ solar devices based on triple layer structure with and without treatment by 5-AVAI

| | $J_{SC}$ [mA $cm^{-2}$] | $V_{OC}$ [mV] | *FF* | PCE [%] |
|---|---|---|---|---|
| **5-AVAI** | 21.1 | 843 | 0.61 | 11.6 |
| **No 5-AVAI** | 13.9 | 855 | 0.65 | 7.2 |

Example 4: Fabrication of perovskite based mesoscopic solar cells treated with mixed templating agent 5-AVAI and 5-APACl:

As presented in Figure 2, the FTO glass was first etched to form two separated electrodes before being cleaned ultrasonically with ethanol. Then, the patterned substrates were coated by a compact $TiO_2$ layer by aerosol spray pyrolysis, and a 1μm nanoporous $TiO_2$ layer was deposited by screen printing of a $TiO_2$ slurry, which prepared as reported previously. After being sintered at 450°C for 30min, a 2μm $ZrO_2$ space layer was printed on the top of the nanoporous $TiO_2$ layer using a $ZrO_2$ slurry, which acts as a insulating layer to prevent electrons from reaching the back contact. Finally, a carbon black/graphite counter electrode or whole selective back contact with the thickness of about 10μm was coated on the top of $ZrO_2$ layer by printing carbon black/graphite composite slurry and sintering at 400°C for 30 min. After cooling down to room temperature, the module was first treated with a 40 mg/mL templating agent solution

of 5-AVAI (5-ammoniumvaleric acid iodide) by drop-casting the templating agent solution on the top of the carbon counter electrode, then drying the module at 50 °C and washed by toluene for three times. After that, The $(5\text{-APA})_x(MA)_{1-x}PbI_{3-x}Cl_x$ precursor solution was infiltrated by drop casting via the top of the carbon counter electrode. After drying at 50 °C for one hour, the mesoscopic solar cells containing perovskite was obtained.

**Table 2** Photovoltaic parameters derived from *J-V* measurements of $CH_3NH_3PbI_3$ solar devices based on triple layer structure with and without treatment by mixed templating agents 5-AVAI and 5-APACl

| | $J_{SC}$ [mA cm$^{-2}$] | $V_{OC}$ [mV] | *FF* | PCE [%] |
|---|---|---|---|---|
| **Mixed 5-AVAI and 5-APACl** | 22.1 | 952 | 0.60 | 12.7 |
| **No 5-AVAI and 5-APACl** | 12.9 | 950 | 0.65 | 8.1 |

Example 4: Fabrication of perovskite based mesoscopic solar cells treated with 4-ABPACl:

Patterned transparent conducting oxide substrates were coated with a $TiO_2$ compact layer by aerosol spray pyrolysis. On the prepared dense $TiO_2$ blocking layer, a 350-nm-thick mesoporous $TiO_2$ layer composed of 36-nm-sized particles was then deposited by spin coating and annealed at 500°C for 0.5 h. The sintered $TiO_2$ films were immersed in 0.02 M aqueous $TiCl_4$ (Aldrich) solution at 70°C for 20 min, which was heated at 500°C for 30 min. The mesoporous $TiO_2$ films were infiltrated with $PbI_2$ by spin-coating the $(4\text{-ABPA})_x(MA)_{1-x}PbI_{3-x}Cl_x$ precursor solution, followed by drying at room temperature and then heating at 100°C for 8 min. After cooling down to room temperature, the HTM was deposited by spin-coating a solution of spiro-MeOTAD, 4-tert-butylpyridine, lithium bis(trifluoromethylsulphonyl)imide and tris(2-(1H-pyrazol-1-yl)-4-tert-butylpyridine)-cobalt(III) bis(trifluoromethylsulphonyl)imide in chlorobenzene. A 60 nm-thick Au was deposited on the top of the HTM over layer by a thermal evaporation, where Au evaporated under ca. $10^{-6}$ torr vacuum condition.

**Table 3** Photovoltaic parameters derived from *J-V* measurements of $CH_3NH_3PbI_3$ solar devices based on gold electrode with and without treatment by templating agent 4-ABPACl

| | $J_{SC}$ [mA cm$^{-2}$] | $V_{OC}$ [mV] | *FF* | PCE [%] |
|---|---|---|---|---|
| **4-ABPACl** | 23.1 | 981 | 0.68 | 15.4 |
| **No 4-ABPACl** | 17.2 | 811 | 0.61 | 8.5 |

Example 5: Fabrication of perovskite based mesoscopic solar cells treated with mixed templating agents of 4-ABPACl and 5-APACl:

Patterned transparent conducting oxide substrates were coated with a $TiO_2$ compact layer by aerosol spray pyrolysis. On the prepared dense$TiO_2$ blocking layer, a 350-nm-thick mesoporous $TiO_2$ layer composed of 36-nm-sized particles was then deposited by spin coating and annealed at 500°C for 0.5 h. The sintered $TiO_2$ films were immersed in 0.02 M aqueous $TiCl_4$ (Aldrich) solution at 70°C for 20 min, which was heated at 500°C for 30 min. The mesoporous $TiO_2$ films were infiltrated with $PbI_2$ by spin-coating the $(4\text{-ABPA}))_x(5\text{-APA})_y(MA)_{1-x-y}PbI_{3-x-y}Cl_{x+y}$ precursor solution, followed by drying at room temperature and then heating at 100°C for 8 min. After cooling down to room temperature, the HTM was deposited by spin-coating a solution of spiro-MeOTAD, 4-tert-butylpyridine, lithium bis(trifluoromethylsulphonyl)imide and tris(2-(1H-pyrazol-1-yl)-4-tert-butylpyridine)-cobalt(III) bis(trifluoromethylsulphonyl)imide in chlorobenzene. A 60 nm-thick Au was deposited on the top of the HTM over layer by a thermal evaporation, where Au evaporated under ca. $10^{-6}$torr vacuum conditions.

**Table 4** .Photovoltaic parameters derived from *J-V* measurements of $CH_3NH_3PbI_3$ solar devices based on gold electrode with and without mixed templating agent 4-ABPACl and 5-APACl

| | $J_{SC}$ [mA cm$^{-2}$] | $V_{OC}$ [mV] | *FF* | PCE [%] |
|---|---|---|---|---|
| **Mixed 4-ABPACl and 5-APACl** | 21.5 | 1000 | 0.74 | 15.7 |
| **No 4-ABPACl and 5-APACl** | 15.4 | 901 | 0.65 | 8.9 |

**Claims**

**1.** A solid state photovoltaic device comprising a light-absorbing layer containing a light harvester and at least one templating agent, said light-absorbing layer being prepared in a single step.

**2.** The solid state photovoltaic device according to claim 1 further comprising a current collector being coated by an electron selective hole blocking layer being selected from n-type metal oxide, PCBM-like C60 and fullerene derivatives, and a whole selective back contact, **characterized in that** the light-absorbing layer is in electric contact with the electron selective hole blocking layer and with the hole selective back contact.

**3.** The solid state photovoltaic device according to claim 2 further comprising a mesostructure on top of the electron selective hole blocking layer.

**4.** The solid state photovoltaic device according to claim 3, wherein the mesostructure consists of one or more mesoporous metal oxide layers each layer comprising a different metal oxide.

**5.** The solid state photovoltaic device according to anyone of the preceding claims, wherein the templating agent is independently selected from a compound of formula (1)

$$W^1\text{-}U\text{-}W^2\text{-}Z \qquad (1),$$

wherein

$W^1$ is selected from COOH, $PO_3H_2$, $PO_4H_2$, $SO_3H_2$, $SO_4H_2$, CONHOH, and salts thereof;
U is selected from a linear or branched C1 to C30 alkyl;
$W^2$ is a cation selected from $-NH3^+$,$-NH-C(NH_3^+)=NH$, $-N=CH-NH_3^+$; and
Z is an anion selected from Cl, Br, I, CN, NCO, NCS and NCSe.

**6.** The solid state photovoltaic device according to anyone of claims 3-5, wherein the mesoporous layer comprises a metal oxide independently selected from $SiO_2$, $TiO_2$, $SnO_2$, $Fe_2O_3$, ZnO, $WO_3$, $Nb_2O_5$, $MoO_3$, NiO, $SrTiO_3$, $ZrO_2$, and combinations thereof.

**7.** The solid state photovoltaic device according to anyone of the preceding claims, wherein the electron selective hole blocking layer comprises a metal oxide being an oxide of a metal selected from Ti, Sn, Fe, Zn, W, Mo, Nb, SrTi, Si, Ti, Al, Cr, Sn, Mg, Mn, Zr, Ni, and Cu.

**8.** The solid state photovoltaic device according to anyone of the preceding claims further comprises a hole transport layer provided before the whole selective back contact.

**9.** The solid state photovoltaic device according to anyone of claims 1-7 is free of a hole transport layer or hole transport material.

**10.** The solid state photovoltaic device according to anyone of the preceding claims, wherein the whole selective back contact comprises one or more conductive materials selected from Pt, Au, Ni, Cu, Ag, In, Ru, Pd, Rh, Ir, Os, C, graphene, indium doped tin oxide (ITO), fluorine doped tin oxide (FTO), $ZnO-Ga_2O_3$, $ZnO-Al_2O_3$, tin-oxide, antimony doped tin oxide (ATO), $SrGeO_3$ and combination thereof, and from conductive polymer being selected from polymers

comprising polyaniline, polypyrrole, polythiophene, polybenzene, polyethylenedioxythiophene, polypropylenedioxythiophene, polyacetylene and combination thereof.

**11.** The solid state photovoltaic device according to anyone of the preceding claims, wherein the light harvester is an organic-inorganic perovskite.

**12.** The solid state photovoltaic device according to anyone of the preceding claims, wherein the light harvester is an organic-inorganic perovskite of any one of formulae (I), (II), (III), (IV), (V) and/or (VI) below:

$AA'MX_4$ (I)

$AMX_3$ (II)

$AA'N_{2/3}X_4$ (III)

$AN_{2/3}X_3$ (IV)

$BN_{2/3}X_4$ (V)

$BMX_4$ (VI)

wherein,

A and A' are organic, monovalent cations that are independently selected from primary, secondary, tertiary or quaternary organic ammonium compounds, including N-containing heterorings and ring systems, A and A' having independently from 1 to 60 carbons and 1 to 20 heteroatoms;
B is an organic, bivalent cation selected from primary, secondary, tertiary or quaternary organic ammonium compounds having from 1 to 60 carbons and 2-20 heteroatoms and having two positively charged nitrogen atoms;
M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$;
N is selected from the group of $Bi^{3+}$ and $Sb^{3+}$; and,
X are independently selected from $Cl^-$, $Br^-$, $I^-$, $NCS^-$, $CN^-$, and $NCO^-$.

**13.** The solid state photovoltaic device according to anyone of the preceding claims, wherein the templating agent is independently selected from a compound of formula (1)

$W^1$-U-$W^2$-Z (1),

wherein

$W^1$ is selected from COOH, $PO_3H_2$, $PO_4H_2$, $SO_3H_2$, $SO_4H_2$, CONHOH, and salts thereof;
U is selected from a linear or branched C1 to C30 alkyl;
$W^2$ is a cation selected from $-NH3^+$, $-NH-C(NH_3^+)=NH$, $-N=CH-NH_3^+$; and
Z is an anion selected from Cl, Br, I, CN, NCO, NCS and NCSe.

**14.** The solid state photovoltaic device according to anyone of the preceding claims, wherein the templating agents are independently selected from a compound of formula (1)

$W^1$-U-$W^2$-Z (1),

wherein

$W^1$ is selected from COOH, $PO_3H_2$, $PO_4H_2$, $SO_3H_2$, $SO_4H_2$, CONHOH, and salts thereof;
U is selected from a linear or branched C1 to C30 alkyl;
$W^2$ is a cation selected from the group consisting of $-NH3^+$,$-NH-C(NH_3^+)=NH$,$N=CH-NH_3^+$; and
Z is an anion selected from the group consisting of Cl, Br, I, CN, NCO, NCS and NCSe.

**15.** The solid state photovoltaic device according to anyone of the preceding claims is selected from a solid state solar

cell, a mesoscopic solid state solar cell, a solid state heterojunction and a mesoscopic solid state heterojunction.

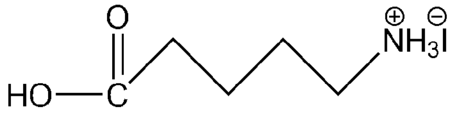

**5-AVAI**

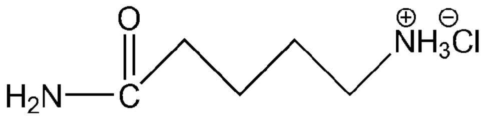

**5-APACl**

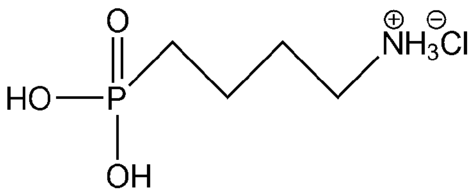

**4-ABPACl**

**Figure 1**

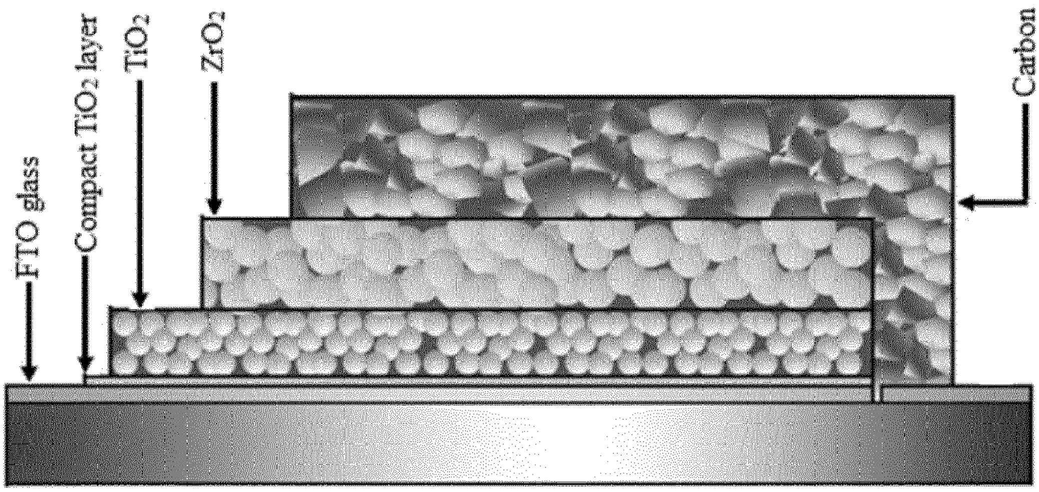


**Figure 2**

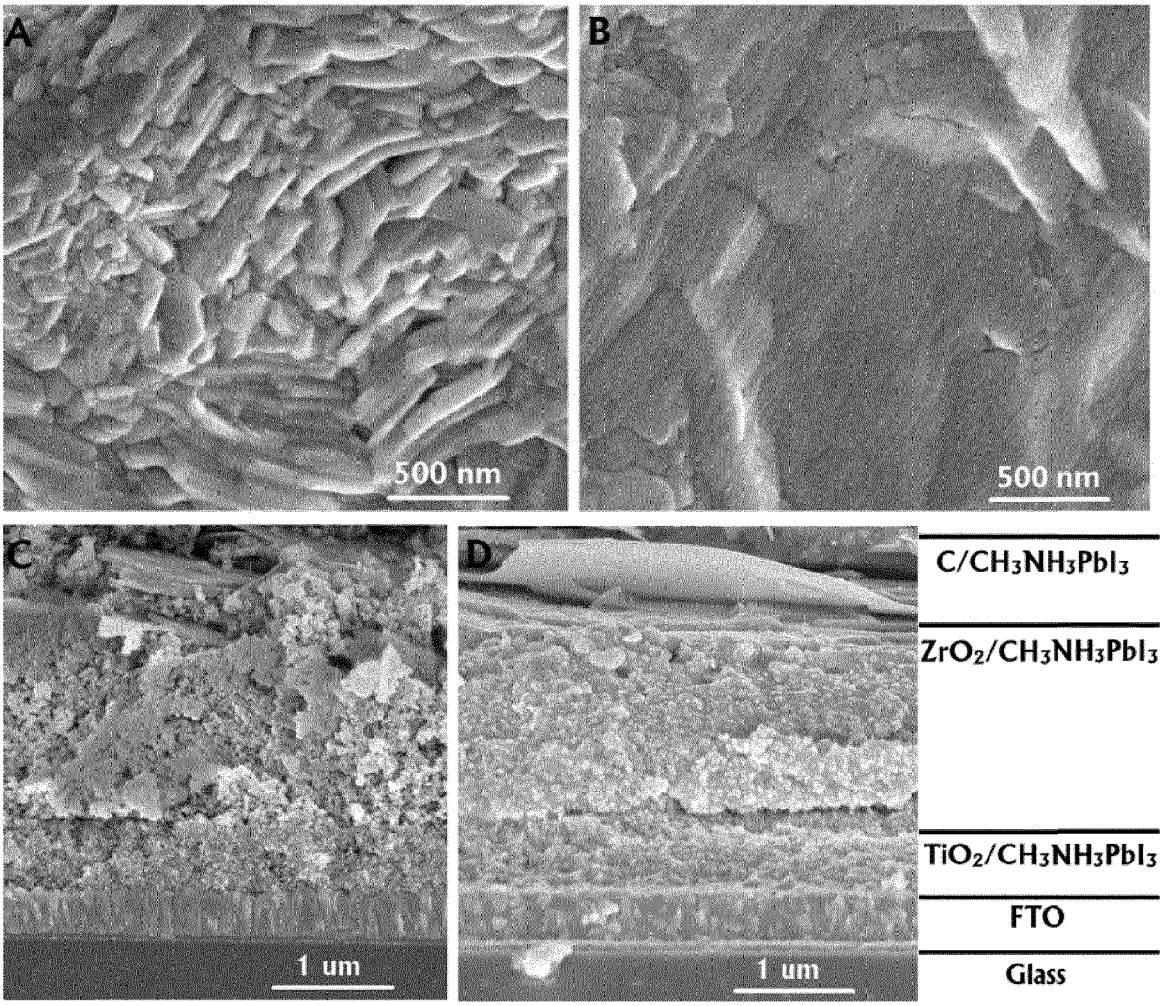
A
500 nm
B
500 nm
C
1 um
D
1 um
C/CH3NH3PbI3
ZrO2/CH3NH3PbI3
TiO2/CH3NH3PbI3
FTO
Glass

Figure 3

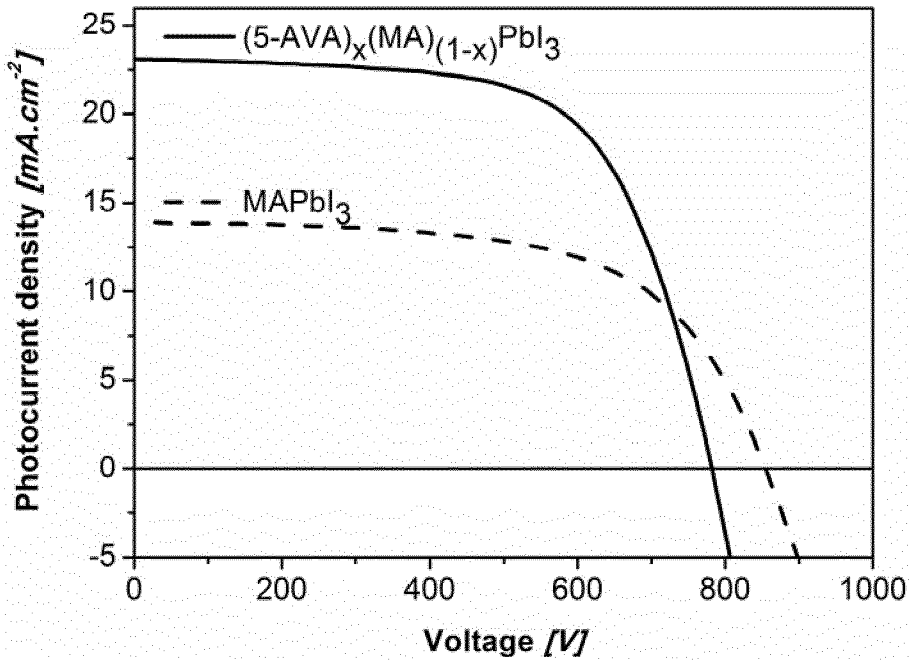


Figure 4

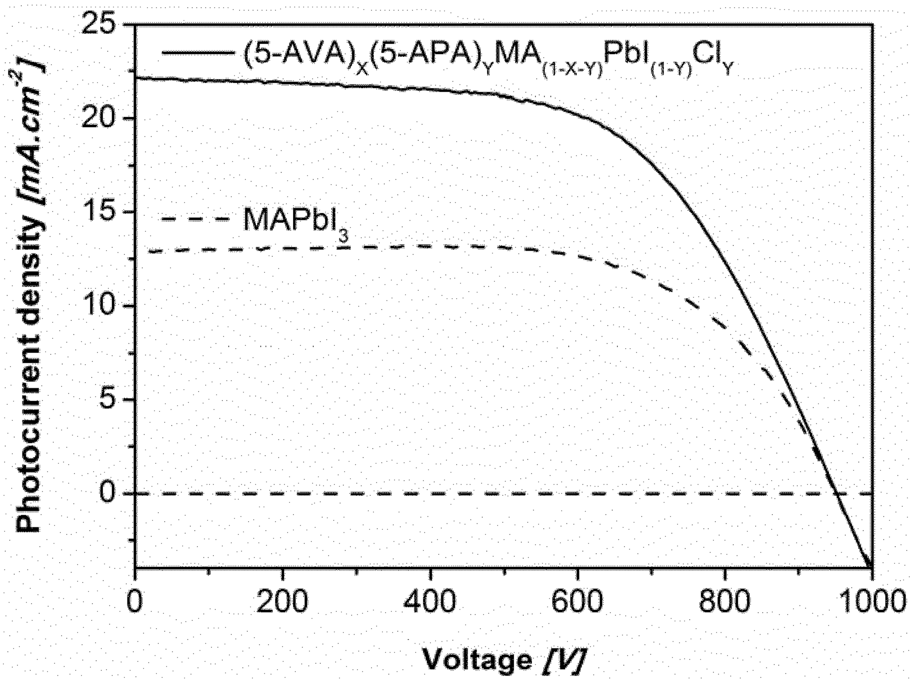


Figure 5

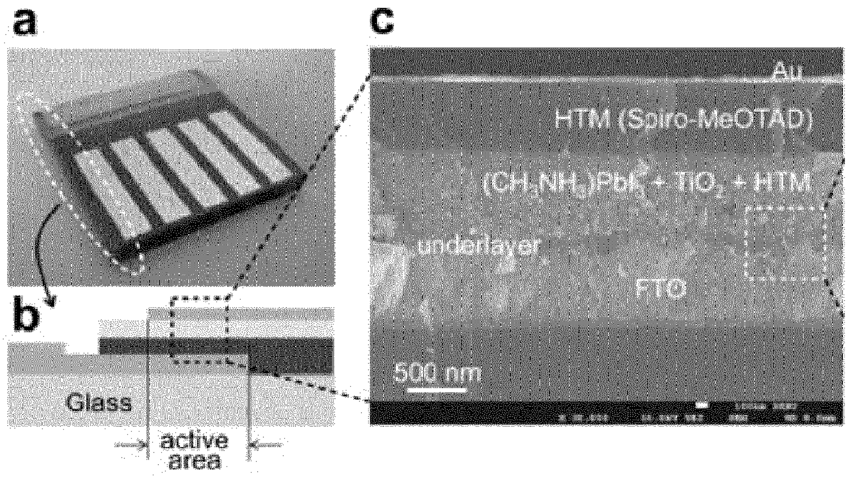


Figure 6

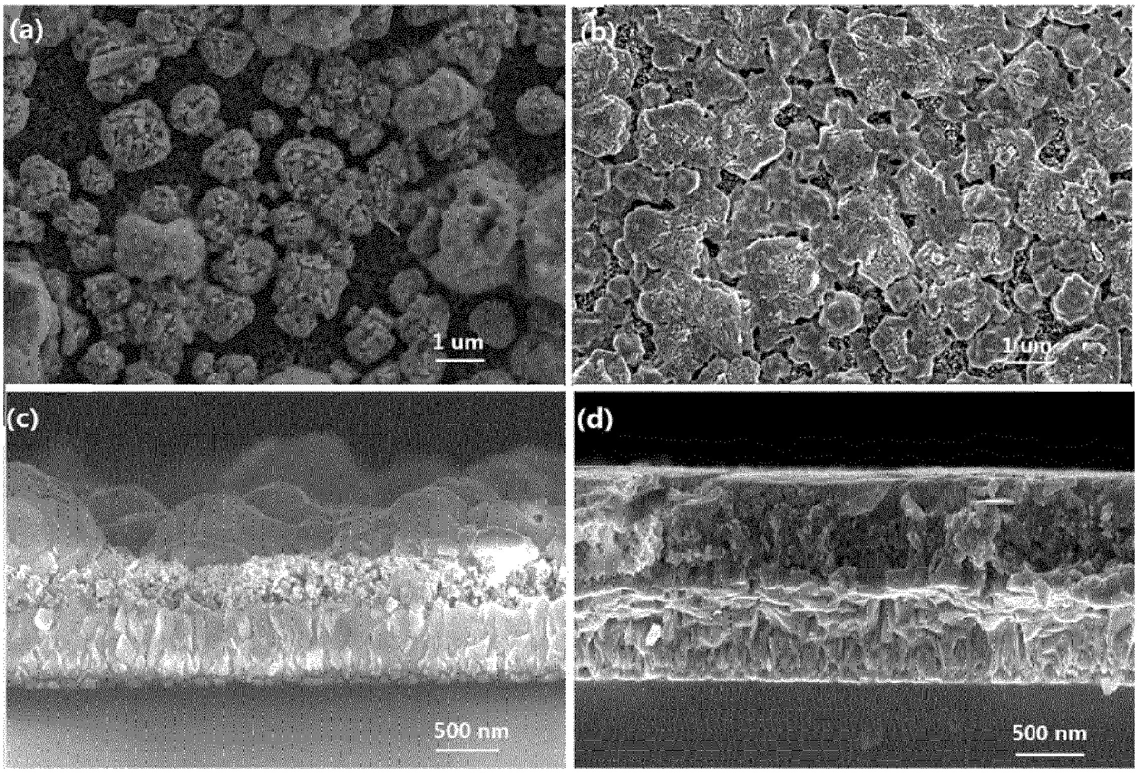


Figure 7

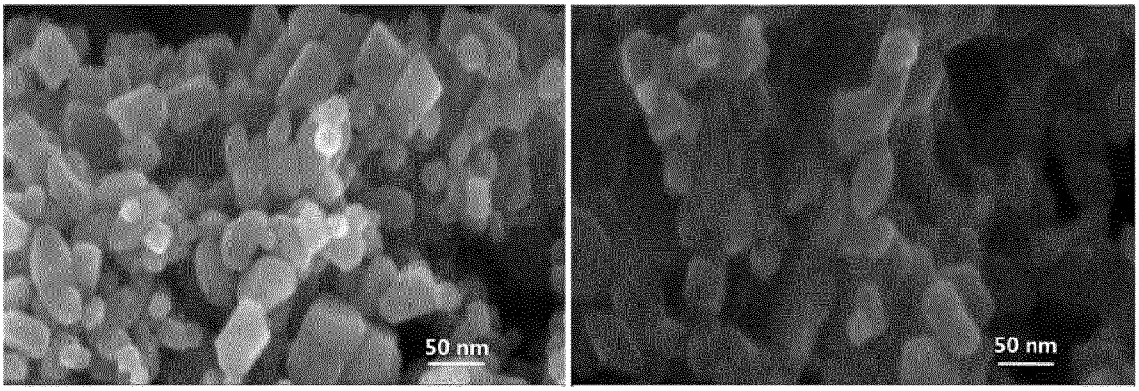


Figure 8

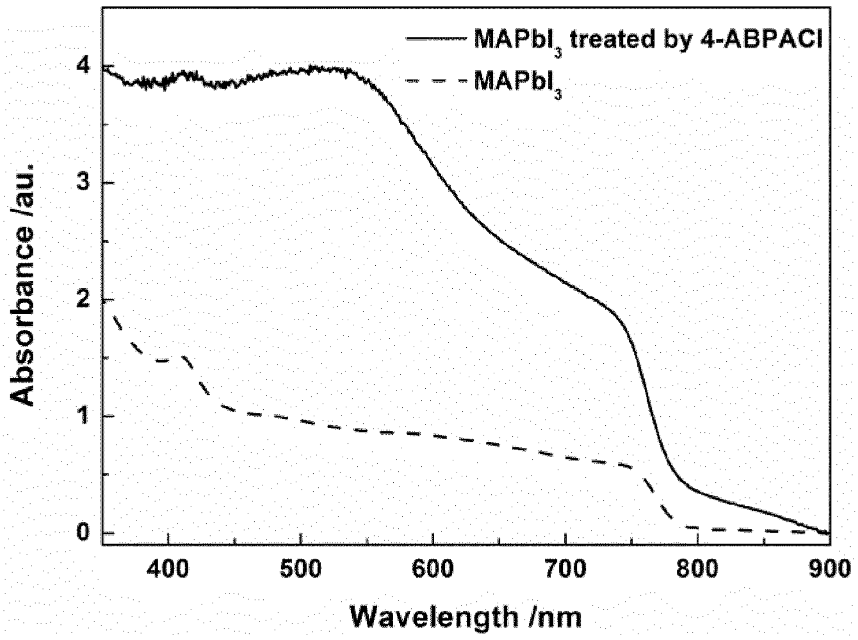


Figure 9

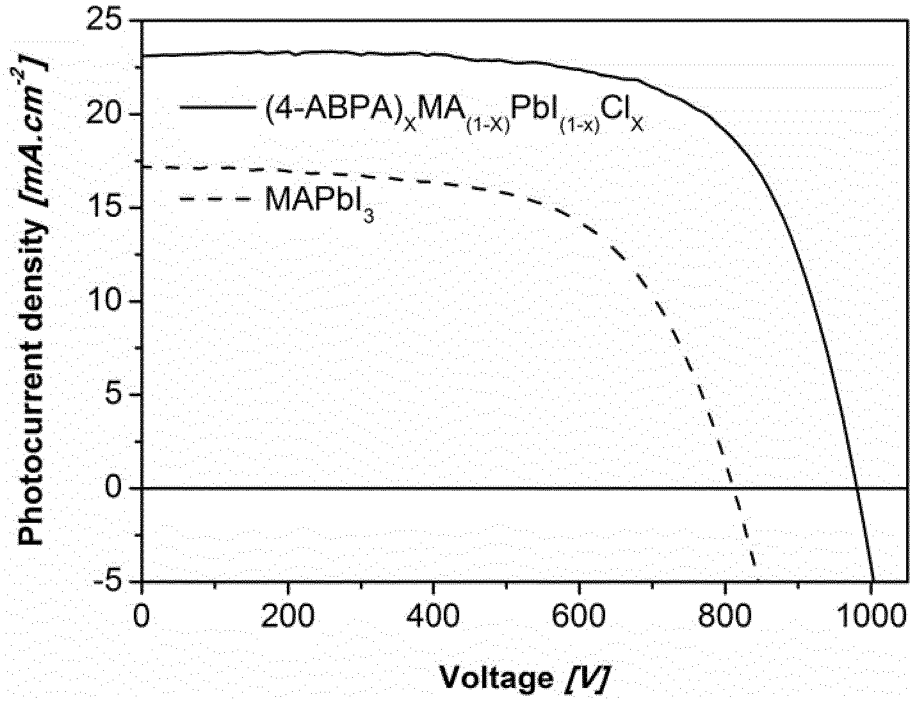


**Figure 10**

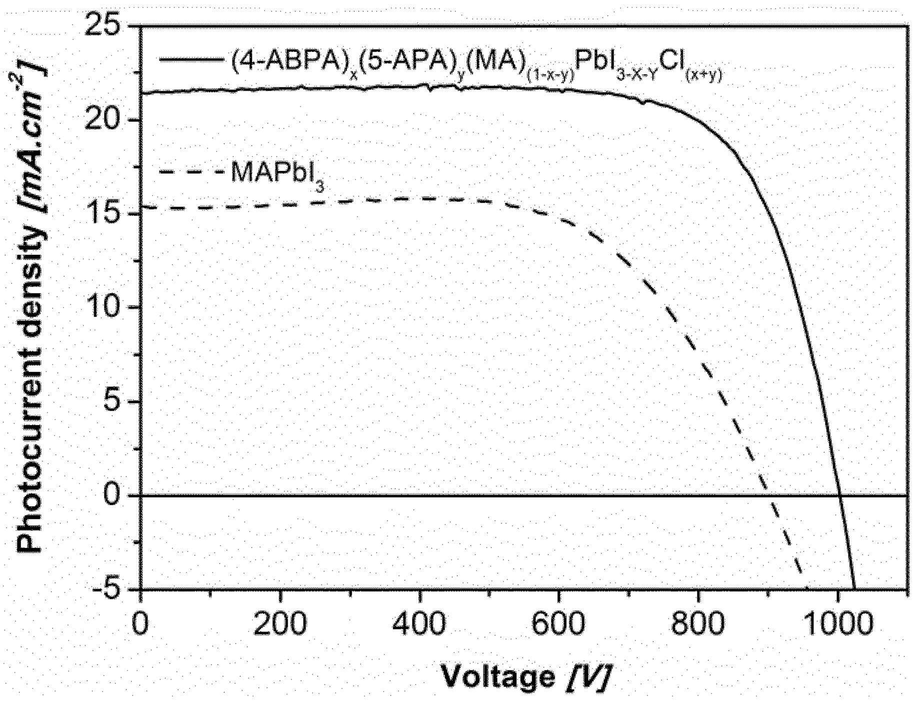


**Figure 11**

Europäisches Patentamt
European Patent Office
Office européen des brevets

# EUROPEAN SEARCH REPORT

Application Number
EP 14 17 6831

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| X | NORMAN PELLET ET AL: "Mixed-Organic-Cation Perovskite Photovoltaics for Enhanced Solar-Light Harvesting", ANGEWANDTE CHEMIE INTERNATIONAL EDITION, vol. 53, no. 12, 19 February 2014 (2014-02-19), pages 3151-3157, XP055162823, ISSN: 1433-7851, DOI: 10.1002/anie.201309361 | 1-3,6,8, 10-12,15 | INV. H01L51/46 |
| Y | * page 3152, column 1, line 30 - line 34 * * page 3152, column 1, line 47 - column 2, line 7 * * page 3153, column 1, line 15 - line 18 * | 1 | |
| X | US 2008/207937 A1 (DAWES STEVEN B [US] ET AL) 28 August 2008 (2008-08-28) * examples 5-7 * | 1 | |
| Y | MITZI D B: "TEMPLATING AND STRUCTURAL ENGINEERING IN ORGANIC-INORGANIC PEROVSKITES", JOURNAL OF THE CHEMICAL SOCIETY, DALTON TRANSACTIONS, CHEMICAL SOCIETY. LETCHWORTH, GB, no. 1, 1 July 2001 (2001-07-01), pages 1-12, XP001147180, ISSN: 1472-7773, DOI: 10.1039/B007070J * page 5, column 1, line 15 - page 6, column 1, line 25; figure 8 * | 1 | TECHNICAL FIELDS SEARCHED (IPC) H01L H01G |

The present search report has been drawn up for all claims

3

| Place of search | Date of completion of the search | Examiner |
|---|---|---|
| Munich | 2 February 2015 | Pusch, Catharina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 17 6831

This annex lists the patent family members relating to the patent documents cited in the above-mentioned European search report.
The members are as contained in the European Patent Office EDP file on
The European Patent Office is in no way liable for these particulars which are merely given for the purpose of information.

02-02-2015

| Patent document cited in search report | Publication date | Patent family member(s) | Publication date |
|---|---|---|---|
| US 2008207937 A1 | 28-08-2008 | EP 2121710 A1 | 25-11-2009 |
| | | JP 2010520862 A | 17-06-2010 |
| | | US 2008207937 A1 | 28-08-2008 |
| | | WO 2008106132 A1 | 04-09-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 12179323 A
- EP 0613466 A
- EP 0758337 A
- EP 0983282 A
- EP 1622178 A
- WO 2006038823 A
- WO 2009107100 A
- WO 2010055471 A
- WO 2011039715 A
- WO 2009098643 A
- EP 1990373 A
- WO 2007100033 A
- EP 11161954 A
- WO 2011054628 W
- WO 2013056648 W
- EP 12182817 A
- EP 0333641 A
- EP 0606453 A
- EP 14153558 A
- EP 14151392 A


### Non-patent literature cited in the description


- **L. ETGAR et al.** *J. Am. Chem. Soc.,* 2012, vol. 134, 17396